Europäisches Patentamt

European Patent Office

Office européen des brevets

(11) Veröffentlichungsnummer: **0 206 350 B1**

(12) **EUROPÄISCHE PATENTSCHRIFT**

(45) Veröffentlichungstag der Patentschrift: **26.08.92**

(21) Anmeldenummer: **86108765.8**

(22) Anmeldetag: **27.06.86**

(51) Int. Cl.5: **H01L 29/743**

(54) **Thyristor mit verminderter Mittelzonendicke.**

(30) Priorität: **28.06.85 DE 3523236**

(43) Veröffentlichungstag der Anmeldung:
**30.12.86 Patentblatt 86/52**

(45) Bekanntmachung des Hinweises auf die
Patenterteilung:
**26.08.92 Patentblatt 92/35**

(84) Benannte Vertragsstaaten:
**DE FR GB**

(56) Entgegenhaltungen:
**EP-A- 0 017 980      EP-A- 0 103 181**
**EP-A- 0 164 292      DE-A- 2 802 843**
**US-A- 3 967 308      US-A- 4 037 245**

**Patent Abstracts of Japan, Band 9, Nr. 85(E-308)(1808), 13. April 1985; & JP A 58 217 365**

**IEEE Transactions on Electron Devices, Vol. ED-27, Nr.2, Seiten 380-387 (1980)**

(73) Patentinhaber: **SIEMENS AKTIENGESELL-SCHAFT**
**Wittelsbacherplatz 2**
**W-8000 München 2(DE)**

(72) Erfinder: **Voss, Peter, Dr.**
**Rudliebstrasse 42**
**W-8000 München 81(DE)**

Rank Xerox (UK) Business Services

**Beschreibung**

Die vorliegende Erfindung bezieht sich auf Thyristoren gemäß den Oberbegriffen der Ansprüche 1 und 8.

Thyristoren dieser Art sind z. B. aus der DE-A-28 02 843 und der EP-A-0 103 181 bekannt. Wesentliche Kenngrößen solcher Thyristoren sind die maximale Sperrspannung in Vorwärts- und Rückwärtsrichtung. Die genannte Sperrspannung ist im wesentlichen von der Dotierung und der Dicke der Mittelzone des Thyristors abhängig. Die Dicke der Mittelzone kann jedoch nicht vollständig ausgenutzt werden. Nähert sich die Raumladungszone ausgehend von dem in Sperrichtung beanspruchten pn-Übergang dem gegenüberliegenden pn-Übergang, d. h. dem pn-Übergang zwischen anodenseitigem Emitter und Mittelzone bzw. zwischen katodenseitiger Basiszone und Mittelzone, so macht sich ein Anstieg des Sperrstroms bemerkbar. Dieser Anstieg rührt daher, daß in der Nähe des in Durchlaßrichtung vorgespannten pn-Übergangs erzeugte Ladungsträgerpaare als Steuerstrom für den pnp-bzw. npn-Teiltransistor des Thyristors wirken.

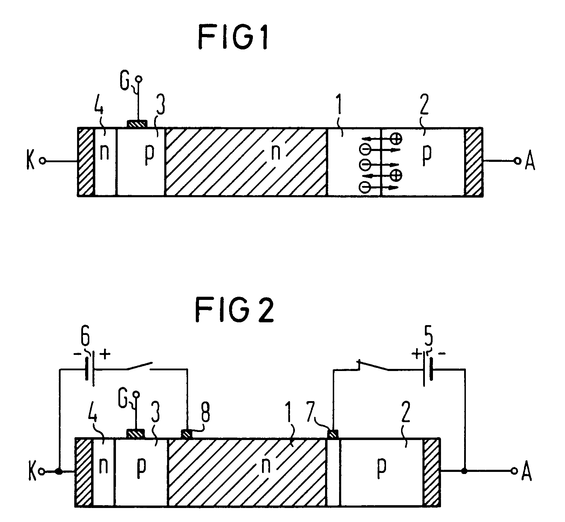

In Figur 1 ist der Halbleiterkörper eines Thyristors schematisch dargestellt. Er besteht aus einer Mittelzone 1, einer anodenseitigen Emitterzone 2, einer katodenseitigen Basiszone 3 und einer katodenseitigen Emitterzone 4. Liegt am Thyristor Sperrspannung in Kipprichtung an, so dehnt sich die Raumladungszone (schraffiert dargestellt) vom pn-Übergang zwischen den Zonen 1, 3 in Richtung auf den pn-Übergang zwischen den Zonen 1, 2 aus. In diesem Fall wirkt der pn-Übergang zwischen den Zonen 1, 2 als Emitter für den aus den Zonen 3, 1, 2 bestehenden pnp-Teiltransistor. Negative Ladungsträger bewegen sich aus der Zone 1 zur Zone 2, positive Ladungsträger aus der Zone 2 in die Zone 1. Je näher die Raumladungszone an den pn-Übergang zwischen den Zonen 1, 2 heranreicht, desto größer wird der Sperrstrom, der durch Transistoreffekt verstärkt wird. Geht dieser Strom in den Steilanstieg, so ist die Grenze der Sperrfähigkeit erreicht.

Bei Anlegen einer Sperrspannung in der anderen Richtung (Sperrichtung) wird der pn-Übergang zwischen den Zonen 1, 2 in Sperrichtung vorgespannt. Dann ist der pn-Übergang zwischen den Zonen 1 und 3 in Durchlaßrichtung vorgespannt und die Raumladungszone muß einen bestimmten Abstand zu diesem pn-Übergang einhalten, wenn der Punch-Through-Durchbruch vermieden werden soll.

Die Mittelzone muß daher dicker gemacht werden, als dies zur Erzielung der gewünschten Durchbruchspannung notwendig wäre. Die Vergrößerung der Mittelzonenbreite bringt jedoch eine Erhöhung der Durchlaßverluste und eine Erhöhung der Trägerspeicherladung mit sich. Letztere erhöht die Freiwerdezeit und das Rückstromintegral.

Der Erfindung liegt die Aufgabe zugrunde, einen Thyristor der eingangs erwähnten Gattung so weiterzubilden, daß die Dicke der Mittelzone verglichen mit bekannten Thyristoren gleicher Nennsperrspannung reduziert werden kann.

Diese Aufgabe wird durch die kennzeichnenden Merkmale der Ansprüche 1 und 8 gelöst. Diese Ansprüche umfassen zwei Ausgestaltungen ein und desselben Lösungsprinzips. Weiterbildungen der Erfindung sind Gegenstand der Unteransprüche.

Die Erfindung wird anhand einiger Ausführungsbeispiele in Verbindung mit den Fig. 2 bis 8 näher erläutert. Es zeigen:

Fig. 2    Die prinzipielle Darstellung eines Thyristors gemäß der Erfindung mit Kontaktbereichen an der Mittelzone,

Fig. 3    den Schnitt durch ein erstes Ausführungsbeispiel eines Thyristors,

Fig. 4 und 5    zwei Möglichkeiten der räumlichen Zuordnung verschiedener Zonen des Halbleiterkörpers nach Fig. 3,

Fig. 6 bis 8    den Schnitt durch die Halbleiterkörper von Thyristoren weiterer Ausführungsbeispiele.

Der Halbleiterkörper des Tyristors nach Fig. 2 trägt die gleichen Bezugszeichen wie in Fig. 1. Er ist zusätzlich in der Nähe der pn-Übergänge zwischen den Zonen 1, 2 bzw. 1, 3 mit Elektroden 7, 8 versehen, die die Mittelzone 1 kontaktieren. Die Kontakte 7, 8 sind mit Stromquellen 5 bzw. 6 verbunden. Diese Stromquellen sind so gepolt, daß zwischen der Raumladungszone und dem gegenüberliegenden pn-Übergang, in diesem Fall dem pn-Übergang zwischen den Zonen 1, 2, thermisch erzeugte Elektronen abgesaugt werden. Die positiven Ladungsträger fließen durch die Zone 3 zur Katodenelektrode. Bei einer Belastung des Thyristors in Sperrichtung wird die Stromquelle 6 an den Kontakt 8 und die Katodenelektrode gelegt, wodurch in der Nähe des zwischen den Zonen 1, 3 liegenden pn-Übergangs erzeugte negative Ladungsträger zur Stromquelle 6 abfließen.

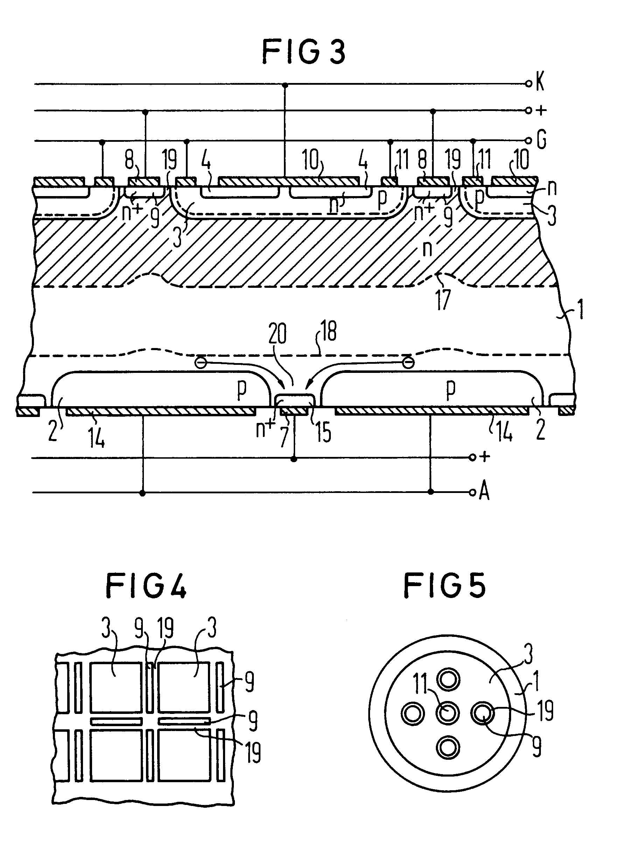

Die Zonen des Ausführungsbeispiels nach Fig. 3 tragen die gleichen Bezugszeichen wie die in Fig. 2. Die anodenseitige Emitterzone 2 und die katodenseitige Basiszone 3 ist hier jeweils planar in eine der Oberflächen des Halbleiterkörpers eingebettet. Die katodenseitige Emitterzone 4 wiederum ist in die katodenseitige Basiszone 3 planar eingebettet. Die Zonen 2, 3 sind mit Aussparungen 19, 20 versehen, durch die die Mittelzone 1 sowohl an die katodenseitige als auch an die anodenseitige Oberfläche des Halbleiterkörpers reicht. In den Aussparungen 19, 20 sitzen Kontaktbereiche 9, 15, die den gleichen Leitungstyp wie die Mittelzone 1 haben, jedoch höher dotiert sind. Die Kontaktbereiche 9, 15 sind mit den Kontakten 8 bzw. 7 kontaktiert, die im Ausführungsbeispiel mit der eingezeichneten Leitungstypfolge npnp an den positiven Pol einer Stromquelle anschließbar sind.

Die katodenseitige Emitterzone 4 ist mit einer Katodenelektrode 10 kontaktiert, die katodenseitige Basiszone 3 mit Zündelektroden 11. Die anodenseitige Emitterzone 2 trägt eine Anodenelektrode 14.

Bei Belastung des Thyristors in Kipprichtung breitet sich die Raumladungszone (schraffiert dargestellt) ausgehend vom pn-Übergang zwischen den Zonen 1, 3 zur Anodenseite aus. In diesem Fall wird der Kontaktbereich 15 über den Kontakt 7 an den positiven Anschluß einer Stromquelle gelegt. In der Raumladungszone erzeugte Elektronen fließen dann parallel zum pn-Übergang zwischen den Zonen 1 und 2 zum Kontaktbereich 15 ab. Diese Elektronen können damit keine Emission von positiven Ladungsträgern aus der Emitterzone 2 hervorrufen, so daß dem aus den Zonen 3, 1 und 2 gebildeten Teilthyristor kein Steuerstrom zur Verfügung steht. Die Raumladungszone kann daher, ohne daß Gefahr des Punch-Through besteht, bis in die Nähe des pn-Übergangs zwischen den Zonen 1 und 2 ausgedehnt werden. Diese Ausdehnung ist durch die gestrichelte Linie 18 angedeutet.

Beim Abfließen der Ladungsträger parallel zum pn-Übergang zwischen den Zonen 1, 2 entsteht dort ein Spannungsabfall. Dieser als Spannung am pn-Übergang wirkende Spannungsabfall darf in der Praxis 0,5 V nicht übersteigen, wenn eine Emission aus dem anodenseitigen Emitter 2 verhindert werden soll. Die gleichen Gesichtspunkte gelten für den Fall der Belastung des Thyristors in Sperrrichtung für die am pn-Übergang zwischen den Zonen 1 und 3 abfallende Spannung. Die lateralen Abmessungen der Zonen 2 und 3 sind daher so gewählt, daß die kritische Spannung von 0,5 V beim höchstzulässigen Sperrstrom nicht überschritten wird.

Die Aussparungen 19 bzw. 20 bewirken Krümmungen der Raumladungszone, die in Fig. 3 mit 17 bezeichnet sind. Diese führen zur Verminderung der Sperrspannung und müssen daher so klein wie möglich gehalten werden. Dies wird dadurch erreicht, daß die lateralen Abmessungen der Aussparungen 19, 20 klein gegenüber der Dicke der Mittelzone 1 gewählt werden. Es empfiehlt sich außerdem, die Kontaktbereiche 9, 15 nicht an die pn-Übergänge zwischen den Zonen 1 und 2 bzw. 1 und 3 anstoßen zu lassen. Damit tritt ein Teil der niedrig dotierten Mittelzone 1 innerhalb der Aussparungen 19 bzw. 20 an die Oberfläche des Halbleiterkörpers und die Sperrwirkung der niedrig dotierten Zone 1 bleibt auch an der Oberfläche erhalten.

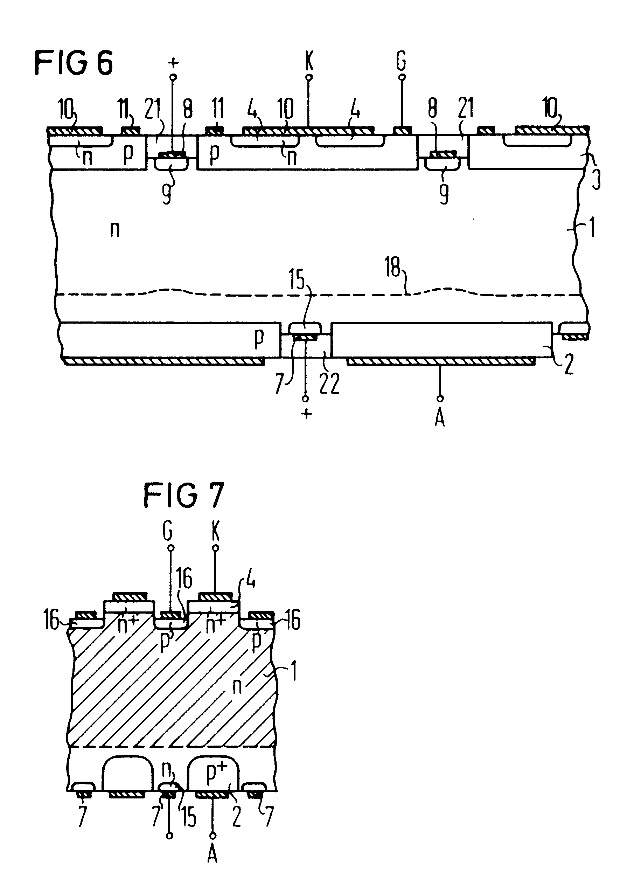

Die Zonen 2, 3 können als einzelne, voneinander getrennte Inseln in die Oberfläche des Halbleiterkörpers eingebettet sein, wie dies für die Zonen 3 in Fig. 4 dargestellt ist. Die Aussparungen 19 bzw. 20 treten dann zwischen den Inseln als zusammenhängendes Netzmuster an die Oberfläche des Halbleiterkörpers. Die Kontaktbereiche 9 bzw. 15 können ebenfalls ein zusammenhängendes Netz bilden oder, wie in Fig. 4 dargestellt, streifenförmige, zwischen je zwei der Inseln angeordnete Inseln bilden. Um den Einfluß der Raumladungszonenkrümmung an den Kreuzungspunkten auf die Sperrfähigkeit möglichst klein zu halten, können auch die Aussparungen 19 und 20 als separate Streifen ausgebildet sein. Dann ist die Zone 3 in sich zusammenhängend ausgebildet. In Fig. 4 wurden der besseren Übersichtlichkeit halber sämtliche Elektroden weggelassen. Anstelle der gezeigten quadratischen Inseln 3 können die Zonen 2, 3 auch Streifen sein.

In Fig. 5 ist der Fall dargestellt, daß die Zone 3 eine einzige zusammenhängende Zone bildet, innerhalb der die Aussparungen 19 an die Oberfläche des Halbleiterkörpers kommen. Hier bilden die Kontaktbereiche 9 Inseln innerhalb der Aussparungen 19. Eine entsprechende Gestaltung kann für die anodenseitige Emitterzone 2 gewählt werden.

Wird für die Ausbildung der Zonen 2 und 3 eine Inselstruktur gewählt, so ist auch die Katodenelektrode 10 in einzelne Inseln aufgeteilt. Diese Teilelektroden sind dann durch entsprechende Verdrahtung oder eine Metallisierungslage miteinander verbunden. Entsprechendes gilt für die Steuerelektrode 11, die Elektroden 7, 8 und die Anodenelektrode 14.

Typische Ausführungsbeispiele für eine Spannung von 0 V (und +10 V) an den Kontaktbereichen haben folgende Lateralabmessungen:
Zonen 2, 3 = 0,7 (5,0) mm, Zone 4 = 0,5 (4,5) mm, Elektroden 10, 14 = 0,4 (4,3) mm, Kontaktbereiche 9,15 = 70 $\mu$m, Aussparungen 19, 20 = 100 $\mu$m.

In der Fig. 6 ist ein gegenüber der Fig. 3 abgewandeltes Ausführungsbeispiel gezeigt. Es unterscheidet sich von dem nach Fig. 3 im wesentlichen dadurch, daß die Kontakte 7, 8 und die Kontaktbereiche 9, 15 in Vertiefungen 21, 22 angeordnet sind. Hiermit ergibt sich eine einfachere Kontaktierung insbesondere auf der Anodenseite, da hier eine durchgehende flache Zuführungselektrode verwendet werden kann. Auf der Katodenseite kann eine vereinfachte Kontaktelektrode verwendet werden, da hier nur noch die Katodenelektrode 10 und die Gateelektrode 11 in gleicher Höhe liegt. Bezüglich der lateralen Abmessungen und Abstände gilt Entsprechendes wie für das Ausführungsbeispiel nach Fig. 3.

In Fig. 7 ist ein sogenannter Static-Induction-Thyristor (SIT) dargestellt, d. h. ein vertikaler Junction-Feldeffekt-Thyristor. Dieser weist an der katodenseitigen Oberfläche des Halbleiterkörpers Emitterzonen 4 und abgesenkte Gatebereiche 16 mit gegenüber der Mittelzone 1 entgegengesetztem Leitungstyp auf. Die Anordnung auf der anderen Seite des Halbleiterkörpers, der Anodenseite, entspricht dem Ausführungsbeispiel nach Fig. 3, könnte aber auch in gleicher Weise wie die Katodenseite ausgebildet sein. Wird an die Gateelektrode G eine negative Spannung gegeben, so baut sich ausgehend von den Zonen 16 eine Raumladungszone auf, die sich zur Anodenseite ausdehnt. Damit wird die Emitterzone 4 abgeschaltet und der Thyristor sperrt. Mit Steuerspannung 0 V am Gate G wird er leitend gesteuert. Die Raumladungszone kann sich wie bei den vorigen Ausführungsbeispielen bis nahe an den pn-Übergang zwischen den Zonen 1 und 2 ausdehnen, ohne daß ein Punch-Through-Durchbruch zu befürchten ist. Die im Sperrfall entstehenden Ladungsträger werden wiederum durch die Kontaktbereiche 15 und die Kontaktelektroden 7 abgesaugt. Die anodenseitigen Emitterzonen 2 können, wie in Verbindung mit Fig. 3 beschrieben, inselförmig ausgebildet sein oder eine einzige zusammenhängende Zone bilden, in denen die Kontaktzonen 15 inselförmig an die anodenseitige Oberfläche treten.

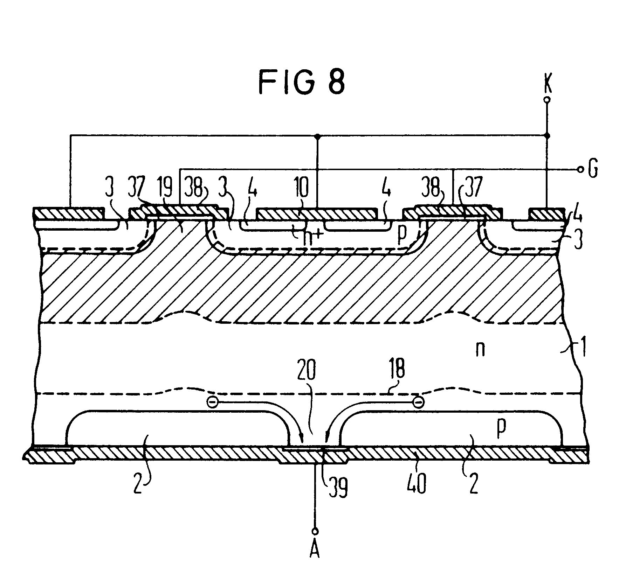

Für die Ausführungsbeispiele nach den Fig. 3 und 6 ist mindestens eine gesonderte Stromquelle notwendig, die je nach Richtung der Sperrbelastung an die entsprechenden Kontaktbereiche geschaltet werden muß. Ein einfacheres Ausführungsbeispiel, das ohne gesonderte Stromquelle auskommt, ist in Fig. 8 dargestellt. Dieses Ausführungsbeispiel unterscheidet sich von dem nach Fig. 3 im wesentlichen durch Schottky-Kontakte zur Kontaktierung der Kontaktbereiche. Die katodenseitigen Schottky-Kontakte sind mit 37 bezeichnet und bedecken die Mittelzone 1 dort, wo sie innerhalb der katodenseitigen Basiszone 3 in den Aussparungen 19 an die Oberfläche des Halbleiterkörpers tritt. Die anodenseitigen Schottky-Kontakte sind mit 39 bezeichnet und bedecken die Mittelzone 1 dort, wo sie innerhalb der Aussparungen 20 an die anodenseitige Oberfläche des Halbleiterkörpers tritt. Die Schottky-Kontakte bestehen aus einer Metallegierung, die mit n-dotiertem Halbleitermaterial einen Schottky-Kontakt bildet, z. B. Platinsilicid. Die Schottky-Kontakte 37, 39 überlappen die katodenseitige Basiszone 3 bzw. die anodenseitige Emitterzone 2 zweckmäßigerweise etwas, um die Fläche der Aussparungen 19, 20 sicher gegen die Metallisierung 38 abzudecken. Eine Überlappung der p-Gebiete schadet nicht, da die oben erwähnte Metallegierung mit p-dotiertem Silicium keinen Schottky-Kontakt bildet. Die Schotty-Kontakte selbst sind durch beispielsweise aus Aluminium bestehende Kontakte 38, 39 kontaktiert. Die Kontakte 38 bilden auch die Gatekontakte für die Zonen 3. Beide sind mit dem Gateanschluß G verbunden. Der Kontakt für den anodenseitigen Schottky-Kontakt 39 ist eine ganzflächige Anodenelektrode 40, die beispielsweise ebenfalls aus Aluminium bestehen kann.

Für die lateralen Abmessungen der Zonen und die lateralen Abmessungen der Aussparungen 19, 20 gilt Entsprechendes wie für das Ausführungsbeispiel nach Fig. 3 für die Spannung 0 V.

Wird der Thyristor mit einer Sperrspannung in Kipprichtung belastet, so bildet sich die eingezeichnete Raumladungszone aus. Diese kann sich etwa bis zur gestrichelten Linie 18 ausdehnen, da in der Raumladungszone erzeugte negative Ladungsträger über den Schottky-Kontakt 39 zur Anode A abgeführt werden. Bei Belastung in Sperrrichtung baut sich die Raumladungszone ausgehend vom pn-Übergang zwischen den Zonen 1, 2 in Richtung zur Katode auf. Im Sperrzustand erzeugte negative Ladungsträger werden jetzt über die Schottky-Kontakte 37, die Kontakte 38 in die Zone 3 abfließen, wo sie durch den durch die Elektrode 10 gebildeten Nebenchluß zwischen den Zonen 3, 4 zur Katode K abfließen können. Die lateralen Abmessungen der katodenseitigen Emitterzone 4 sind daher auf die bekannte Weise so zu bestimmen, daß der laterale Spannungsabfall, den der Sperrstrom verursacht, nicht zu einer Emission von negativen Ladungsträgern aus der Emitterzone 4 führt.

Die Zonen 2, 3 können, wie bereits im Verbindung mit Fig. 3 beschrieben, als Inseln ausgebildet sein, zwischen denen die Aussparungen 19, 20 zusammenhängend an die Oberfläche des Halbleiterkörpers treten. Die Schottky-Kontakte 38, 39 können als zusammenhängendes Netz oder als beispielsweise streifenförmige Inseln auf den Aussparungen 19, 20 angeordnet sein. Die Schottky-Kontakte sollten aber auch hier die Aussparungen 19, 20 gut ausfüllen, indem sie die Zonen 2, 3 mindestens teilweise überlappen. Die Zonen 2, 3 können auch zusammenhängend als jeweils eine einzige Zone ausgebildet sein, während die Schottky-Kontakte 37, 39 als Inseln auf den Aussparungen 19, 20 angeordnet sind.

Für alle Ausführungsbeispiele empfiehlt es sich, die Kontaktbereiche nicht gegenüber denjenigen Bereichen anzuordnen, von denen die Zündung des Thyristors ausgeht. Vorzugsweise werden die Bereiche daher gegeneinander versetzt angeordnet.

**Bezugszeichenliste**

1          Mittelzone

| | |
|---|---|
| 2 | Emitterzone |
| 3 | Basiszone |
| 4 | Emitterzone |
| 5, 6 | Stromquelle |
| 7, 8 | Elektrode |
| 9 | Kontaktbereich |
| 10 | Katodenelektrode |
| 11 | Zündelektrode |
| 14 | Anodenelektrode |
| 15 | Kontaktbereich |
| 16 | Gatebereich |
| 17 | Krümmung |
| 18 | Linie |
| 19, 20 | Aussparung |
| 21, 22 | Vertiefung |
| 23 | Katodenkontakt |
| 24 | Gatezone |
| 25 | Isolierschicht |
| 26 | Gateelektrode |
| 28 | Zone |
| 29 | Aussparung |
| 30 | Sourcezone |
| 31 | Anodenkontakt |
| 32 | Oxidschicht |
| 33 | Gateelektrode |
| 34 | Gatezone |
| 36 | Sourcezone |
| 37 | Schottky-Kontakt |
| 38 | Kontakt |
| 39 | Schottky-Kontakt |
| 40 | Anodenelektrode |
| G | Gateelektrode |
| K | Katodenelektrode |
| A | Anodenelektrode |
| GK1, GK2 | Gatekontakt |

## Patentansprüche

1. Thyristor mit einem Halbleiterkörper mit einer Mittelzone (1) vom ersten Leitungstyp und einer gegebenen Dotierungshöhe, mit mindestens einer katodenseitigen Basiszone (3) und einer anodenseitigen Emitterzone (2) vom zweiten Leitungstyp, mit mindestens einer Katodenelektrode (10) und mindestens einer Anodenelektrode (14) und mit mindestens einem Bereich (20) der Mittelzone, der anodenseitig an die Oberfläche des Halbleiterkörpers tritt und dort mit einer Elektrode (7) versehen ist, **gekennzeichnet durch** die Merkmale:

   a) die Mittelzone (1) hat mindestens einen Bereich (19), der katodenseitig an die Oberfläche des Halbleiterkörpers tritt,

   b) innerhalb der anoden- und katodenseitigen Bereiche (19, 20) sind Kontaktbereiche (9, 15) vorgesehen, die den gleichen Leitungstyp wie die Mittelzone (1), jedoch eine höhere Dotierungskonzentration als diese haben,

   c) die Kontaktbereiche (9, 15) sind mit Kontakten (7, 8) versehen, die an positives Potential angeschlossen werden.

2. Thyristor nach Anspruch 1, **dadurch gekennzeichnet,** daß die Bereiche (19, 20) ein zusammenhängendes Netz bilden, daß die anodenseitige Emitterzone (2) und die katodenseitige Basiszone (3) jeweils in Form von mehreren, voneinander getrennten Inseln in die Mittelzone eingebettet sind und daß die Kontaktbereiche (9, 15) zwischen den Inseln ebenfalls in die Mittelzone eingebettet sind.

3. Thyristor nach Anspruch 2, **dadurch gekennzeichnet,** daß die Inseln und die Kontaktbereiche streifenförmig ausgebildet sind.

4. Thyristor nach Anspruch 1, **dadurch gekennzeichnet,** daß die anodenseitige Emitterzone (2) und die katodenseitige Basiszone (3) jeweils eine einzige zusammenhängende Zone bilden und daß die Kontaktbereiche (9, 15) Inseln bilden und innerhalb der Bereiche (19, 20) in die Mittelzone eingebettet sind.

5. Thyristor nach einem der Ansprüche 1 bis 4, **dadurch gekennzeichnet,** daß die Mittelzone (1) zwischen den Kontaktbereichen (9, 15) und der anodenseitigen Emitterzone (2) bzw. der katodenseitigen Basiszone (3) an die Oberfläche des Halbleiterkörpers tritt.

6. Thyristor nach einem der Ansprüche 1 bis 5, **dadurch gekennzeichnet,** daß die katodenseitigen Kontaktbereiche jeweils einer anodenseitigen Emitterzone und die anodenseitigen Kontaktbereiche jeweils einer katodenseitigen Basiszone gegenüberliegen.

7. Thyristor mit einem Halbleiterkörper mit einer Mittelzone (1) vom ersten Leitungstyp und einer gegebenen Dotierungshöhe, mit mindestens einer katodenseitigen Basiszone (3) und einer anodenseitigen Emitterzone (2) vom zweiten Leitungstyp, mit mindestens einer Katodenelektrode (10) und einer Anodenelektrode (40) und mit mindestens einem Bereich (20) der Mittelzone (1), der anodenseitig an die Oberfläche des Halbleiterkörpers tritt und dort mit einem Schottky-Kontakt (39) versehen ist, der von der Anodenelektrode (40) kontaktiert ist, **gekennzeichnet durch** die Merkmale:

   a) die Mittelzone (1) hat mindestens einen Bereich (19), der katodenseitig an die Oberfläche des Halbleiterkörpers tritt,

5

b) der katodenseitige Bereich (19) ist mit einem Schottky-Kontakt (37) versehen, der von einer Elektrode (38) kontaktiert ist,

c) die Elektrode (38) kontaktiert auch die katodenseitige Basiszone (3) und ist mit einer Gatezuführung (G) verbunden.

8. Thyristor nach Anspruch 7, **dadurch gekennzeichnet,** daß die Bereiche (19, 20) ein zusammenhängendes Netz bilden, daß die anodenseitige Emitterzone und die katodenseitige Basiszone als Inseln in die Mittelzone eingebettet sind und daß die Schottky-Kontakte (37, 39) zwischen den Inseln auf der Oberfläche der Mittelzone (1) angeordnet sind.

9. Thyristor nach Anspruch 7, **dadurch gekennzeichnet,** daß die Schottky-Kontakte (37, 39) die katodenseitige Basiszone (3) und die anodenseitige Emitterzone (2) überlappen.

10. Thyristor nach Anspruch 8, **dadurch gekennzeichnet,** daß die Inseln und die Schottky-Kontakte streifenförmig ausgebildet sind.

11. Thyristor nach Anspruch 9, **dadurch gekennzeichnet,** daß die anodenseitige Emitterzone und die katodenseitige Basiszone jeweils eine einzige zusammenhängende Zone bilden und daß die Schottky-Kontakte als Inseln an der Oberfläche der Bereiche angeordnet sind.

**Claims**

1. Thyristor comprising a semiconductor body having a centre zone (1) of the first type of conduction and a given level of doping, having at least one cathode-end base zone (3) and one anode-end emitter zone (2) of the second type of conduction, having at least one cathode electrode (10) and at least one anode electrode (14) and having at least one area (20) of the centre zone which comes to the surface of the semiconductor body at the anode end and is there provided with an electrode (7), characterised by the following features:

   a) the centre zone (1) has at least one area (19) which comes to the surface of the semiconductor body at the cathode end,

   b) within the anode- and cathode-end areas (19, 20), contact areas (9, 15) are provided which have the same type of conduction as the centre zone (1) but a higher doping concentration than this,

   c) the contact areas (9, 15) are provided with contacts (7, 8) which are connected to positive potential.

2. Thyristor according to Claim 1, characterised in that the areas (19, 20) form a coherent grid, in that the anode-end emitter zone (2) and the cathode-end base zone (3) are in each case embedded in the centre zone in the form of several islands isolated from one another, and in that the contact areas (9, 15) are also embedded in the centre zone between the islands.

3. Thyristor according to Claim 2, characterised in that the islands and the contact areas are constructed to be strip-shaped.

4. Thyristor according to Claim 1, characterised in that the anode-end emitter zone (2) and the cathode-end base zone (3) in each case form a single coherent zone and in that the contact areas (9, 15) form islands and are embedded in the centre zone within the areas (19, 20).

5. Thyristor according to one of Claims 1 to 4, characterised in that the centre zone (1) comes to the surface of the semiconductor body between the contact areas (9, 15) and the anode-end emitter zone (2) and, respectively, the cathode-end base zone (3).

6. Thyristor according to one of Claims 1 to 5, characterised in that the cathode-end contact areas are in each case opposite to an anode-end emitter zone and the anode-end contact areas are in each case opposite to a cathode-end base zone.

7. Thyristor comprising a semiconductor body having a centre zone (1) of the first type of conduction and a given level of doping, having at least one cathode-end base zone (3) and one anode-end emitter zone (2) of the second type of conduction, having at least one cathode electrode (10) and one anode electrode (40) and having at least one area (20) of the centre zone (1) which comes to the surface of the semiconductor body at the anode end and is there provided with a Schottky contact (39) which is in contact with the anode electrode (40), characterised by the following features:

   a) the centre zone (1) has at least one area (19) which comes to the surface of the semiconductor body at the cathode end,

   b) the cathode-end area (19) is provided with a Schottky contact (37) which is in contact with an electrode (38),

   c) the electrode (38) is also in contact with the cathode-end base zone (3) and is connected to a gate feed (G).

8. Thyristor according to Claim 7, characterised in that the areas (19, 20) form a coherent grid, in that the anode-end emitter zone and the cathode-end base zone are embedded as islands in the centre zone, and in that the Schottky contacts (37, 39) are arranged between the islands on the surface of the centre zone (1).

9. Thyristor according to Claim 7, characterised in that the Schottky contacts (37, 39) overlap the cathode-end base zone (3) and the anode-end emitter zone (2).

10. Thyristor according to Claim 8, characterised in that the islands and the Schottky contacts are constructed to be strip-shaped.

11. Thyristor according to Claim 9, characterised in that the anode-end emitter zone and the cathode-end base zone in each case form a single coherent zone and in that the Schottky contacts are arranged as islands on the surface of the areas.

**Revendications**

1. Thyristor comportant un corps semiconducteur à zone centrale (1) possédant le premier type de conductivité et une hauteur de dopage donnée, comportant au moins une zone de base (3) située côté cathode et une zone d'émetteur (2) située côté anode et possédant le second type de conductivité, au moins une électrode formant cathode (10) et au moins une électrode formant anode (14) et au moins une région (20) de la zone centrale, qui, côté anode, apparaît au niveau de la surface du corps semiconducteur et y est pourvue d'une électrode (7),
caractérisé par les particularités suivantes :
a) la zone centrale (1) possède au moins une région (19) qui apparaît, côté cathode, au niveau de la surface du corps semiconducteur,
b) dans les régions (19,20) situées côté anode et côté cathode, il est prévu des régions de contact (9,15) qui possèdent le même type de conductivité que la zone centrale (1), mais une concentration de dopage plus élevée que dans cette zone,
c) les régions de contact (9,15) sont pourvues de contacts (7,8), qui sont placés à un potentiel positif.

2. Thyristor suivant la revendication 1, caractérisé par le fait que les régions (19,20) forment un réseau d'un seul tenant, que la zone d'émetteur (2) située côté anode et la zone de base (3) située côté cathode sont insérées dans la zone centrale respectivement sous la forme de plusieurs îlots séparés les uns des autres et que les régions de contact (9,15) sont également insérées dans la zone centrale entre les îlots.

3. Thyristor selon la revendication 2, caractérisé par le fait que les îlots et les régions de contact sont réalisés sous la forme de bandes.

4. Thyristor selon la revendication 1, caractérisé par le fait que la zone d'émetteur (2) située côté anode et la zone de base (3) située côté cathode forment respectivement une seule zone continue et que les régions de contact (9,15) forment des îlots et sont insérées dans la zone centrale, à l'intérieur des régions (19,20).

5. Thyristor suivant l'une des revendications 1 à 4, caractérisé par le fait que la zone centrale (1) s'étend jusqu'à la surface du corps semiconducteur entre les régions de contact (9,15) et la zone d'émetteur (2) située côté anode ou la zone de base (3) située côté cathode.

6. Thyristor suivant l'une des revendications 1 à 5, caractérisé par le fait que les régions de contact situées côté cathode sont disposées respectivement en vis-à-vis d'une zone d'émetteur située côté anode et que les régions de contact situées côté anode sont disposées respectivement en vis-à-vis d'une zone de base située côté cathode.

7. Thyristor comportant un corps semiconducteur pourvu d'une zone centrale (1) possédant le premier type de conductivité et une intensité déterminée de dopage, au moins une zone de base (3) située côté cathode et une zone d'émetteur (2) située côté anode et possédant le second type de conductivité, au moins une électrode formant cathode (10) et une électrode formant anode (40) et au moins une région (20) de la zone centrale (1), qui apparaît côté anode au niveau de la surface du corps semiconducteur et y est pourvue d'un contact Schottky (39), qui est en contact avec l'électrode formant anode (40),
caractérisé par les particularités suivantes
a) la zone centrale (1) possède au moins une région (19), qui apparaît, côté cathode, au niveau de la surface du corps semiconducteur,
b) la région (19) située côté cathode est pourvue d'un contact Schottky (37) qui est en contact avec une électrode (38),

c) l'électrode (38) est également en contact avec la zone de base (3) située côté cathode et est raccordée à un élément d'alimentation de grille (G).

8.  Thyristor suivant la revendication 7, caractérisé par le fait que les régions (19,20) forment un réseau d'un seul tenant, que la zone d'émetteur situé côté anode et que la zone de base située côté cathode sont insérées dans la zone centrale sous la forme d'îlots et que les contacts Schottky (37,39) entre les îlots sont disposés sur la surface de la zone centrale (1).

9.  Thyristor selon la revendication 7, caractérisé par le fait que les contacts Schottky (37,39) chevauchent la zone de base (3) située côté cathode et la zone d'émetteur (2) située côté anode.

10. Thyristor selon la revendication 8, caractérisé par le fait que les îlots et les contacts Schottky sont agencés sous la forme de bandes.

11. Thyristor suivant la revendication 9, caractérisé par le fait que la zone d'émetteur située côté anode et la zone de base située côté cathode forment respectivement une zone unique et d'un seul tenant, et que les contacts Schottky sont réalisés sous la forme d'îlots au niveau de la surface des régions.

## FIG 1

## FIG 2

## FIG 3

## FIG 4

## FIG 5

**FIG 6**

**FIG 7**

FIG 8